# EUROPÄISCHE PATENTANMELDUNG

(11) **EP 3 562 279 A1**
(43) Veröffentlichungstag der Anmeldung: **30.10.2019**
(21) Anmeldenummer: 18169224.5
(22) Anmeldetag: 25.04.2018
(51) Int. Cl.: H05K 3/30

(54) **HERSTELLUNG EINER ELEKTRISCHEN VERBINDUNG VON BAUELEMENTEN MIT EINER KONTAKTIERUNGSPLATTE**

(71) Anmelder: Siemens Aktiengesellschaft, 80333 München (DE)
(72) Erfinder: Pöhler, Dirk, 08056 Zwickau (DE); Wilke, Klaus, 12527 Berlin (DE)

(57) **Zusammenfassung**

Die Erfindung betrifft eine Kontaktierungsplatte (3) für die Herstellung einer elektrischen Verbindung an mindestens ein Bauelement (1), wobei das mindestens eine Bauelement(1) eine Gehäuserückseite (5) aufweist, welche der Kontaktierungsplatte (5) gegenüberliegt, die Erfindung betrifft außerdem ein Verfahren zur Herstellung einer Kontaktierungsplatte (3) sowie die Angabe von Möglichkeiten der elektrischen Kontaktierung zwischen Bauelement und Kontaktierungsplatte aufzuzeigen.

Die Erfindung zeichnet sich dadurch aus, dass zwischen der Kontaktierungsplatte (3) und der Gehäuserückseite (5) des mindestens einen Bauelements (1) eine elektrische Kontaktierung und eine mechanische Befestigung ausgebildet sind.

## Beschreibung

Die Erfindung betrifft eine Kontaktierungsplatte für die Herstellung einer elektrischen Verbindung an mindestens ein Bauelement, wobei das mindestens eine Bauelement eine Gehäuserückseite aufweist, welche der Kontaktierungsplatte gegenüberliegt, die Erfindung betrifft außerdem ein Verfahren zur Herstellung einer Kontaktierungsplatte sowie die Angabe von Möglichkeiten der elektrischen Kontaktierung zwischen Bauelement und Kontaktierungsplatte aufzuzeigen.

Unter einer Backplane wird hier ein Träger für elektrische Bauelemente verstanden, der Leitungen zum elektrischen Verbinden elektrischer Bauelemente aufweist. Derartige elektrische Bauelemente sind beispielsweise Niederspannungsschaltgeräte wie Schütze, Motorschutzschalter, Motorstarter, Sanftstarter oder Relais, oder Steuerungseinheiten oder Eingabe-/Ausgabeeinheiten. In einem Schaltschrank werden elektrische Bauelemente einer technischen Vorrichtung oder Anlage angeordnet. In herkömmlichen Schaltschränken werden elektrische Bauelemente in der Regel auf Hutschienen mechanisch befestigt und durch diskrete isolierte Kabel, die in Kabelkanälen verlegt werden, untereinander bzw. auch nach extern elektrisch verbunden. Bei einer Vielzahl elektrischer Bauelemente entsteht dabei ein hoher Verkabelungsaufwand.

Es besteht nun die Problemstellung, eine weitestgehend kabellose elektrische Kontaktierung von Bauelementen bzw. Schaltgeräten in einem Schaltschrank zu realisieren. Neben dieser elektrischen Kontaktierung der Komponenten muss die mechanische Befestigung umgesetzt, im Einzelfall auch eine thermische Anbindung zur Abfuhr von Wärme gewährleistet werden.

Prinzipiell gibt es eine Vielzahl von Verbindungstechnologien aus dem Bereich der kraftschlüssigen, formschlüssigen oder stoffschlüssigen Fügetechnik wie z.B. auch Federkontakte.

Die Aufgabe der vorliegenden Erfindung besteht darin, eine Kontaktierungsplatte zur Herstellung einer elektrischen Verbindung zu schaffen, ein Verfahren zur Herstellung dieser Kontaktierungsplatte anzugeben sowie Möglichkeiten der elektrischen Kontaktierung zwischen Bauelement und Kontaktierungsplatte aufzuzeigen.

Diese Aufgabe wird erfindungsgemäß durch eine Kontaktierungsplatte mit den Merkmalen des Patentanspruchs 1, durch ein Verfahren mit den Merkmalen des Patentanspruchs 13, durch einen Herstellungsprozess mit den Merkmalen des Patentanspruchs 15 sowie durch ein Kontaktelement mit den Merkmalen des Patentanspruchs 16 gelöst. Vorteilhafte Aus- und Weiterbildungen, welche einzeln oder in Kombination miteinander eingesetzt werden können, sind der Gegenstand der abhängigen Ansprüche.

Erfindungsgemäß wird diese Aufgabe durch eine Kontaktierungsplatte für die Herstellung einer elektrischen Verbindung an mindestens ein Bauelement, insbesondere in einem Schaltschrank gelöst, wobei das mindestens eine Bauelement eine Gehäuserückseite aufweist, welche der Kontaktierungsplatte gegenüberliegt. Die Erfindung zeichnet sich dadurch aus, dass zwischen der Kontaktierungsplatte und der Gehäuserückseite des mindestens einen Bauelements eine elektrische Kontaktierung und eine mechanische Befestigung ausgebildet sind.

Als Ersatz der bisher im Schaltschrank rückseitig verwendeten Montageplatte mit nur mechanisch tragender Funktion kommen nun Kontaktierungsplatten, sogenannte Backplanes, zum Einsatz, die durch additive Fertigungstechnologien wie z.B. Dispensdruck oder Jetting applizierte universale elektrische Leiter aufweisen und individuell kundenspezifisch hergestellt werden können.

Die Erfindung beinhaltet ein bzw. mehrere zusätzliche Kontaktelemente, die zumindest die Funktion der elektrischen Kontaktierung, ggf. auch zusätzlich der mechanischen Kontaktierung übernehmen können. Diese können beispielsweise Kontaktstifte oder Kontaktleisten sein. Die Kontaktstifte können beispielsweise dauerhaft fest in der Kontaktierungsplatte bzw. Backplane befestigt sein, alternativ auch in den zu verarbeitenden Komponenten bspw. auf der Rückseite der elektrischen Bauelemente. Die additiv hergestellten Metallisierungen auf der Kontaktierungsplatte können sich von der Montageseite her betrachtet auf der Rückseite, der Vorderseite oder alternativ auch auf beiden Seiten befinden.

Erfindungsgemäß kann es vorgesehen sein, dass spezielle Kontaktelemente in Form von Kontaktstiften an den Rückseiten der elektrischen Bauelemente angeordnet sind. Die Kontaktstifte können so ausgeführt sein, dass sie hinter der Backplane sich aufspreizende metallische Federelemente aufweisen, die eine elektrische Kontaktierung ermöglichen. Zusätzlich können die metallischen Federelemente eine mechanische Befestigung des Bauelements ermöglichen.

Die Leiterbahnstrukturen sind auf der Rückseite der Backplane ausgeführt und bis an den Rand von Löchern geführt. Beim Einstecken der Geräte verriegeln sich die Kontaktelemente automatisch hinter der Backplane und ergeben somit eine elektrische und mechanische Kontaktierung. Der Vorteil bei dieser Ausführungsform besteht darin, dass die Leiterbahnen auf der Rückseite der Kontaktierungsplatte positioniert sind und somit nicht von vorn zugänglich. Auf diese Weise sind die Leiterbahnen mechanisch bei der Montage gegen Beschädigung geschützt. Zudem wird durch die Verwendung eines lackierten Stahlblechs als Rückwand der Berührungsschutz zu den gedruckten Leiterbahnen umgesetzt. Eine weitere Ausführungsform der Erfindung besteht darin, dass sich Kontaktelemente bzw. Kontaktstifte mit flexibler Einpresszone an den Gehäuserückseiten des Bauelements bzw. Schaltgeräts befinden. Seitens der Kontaktierungsplatte bzw. Backplanes sind gegenüber dem Grundmaterial elektrisch isolierte, metallisierte Löcher notwendig, die mit den additiv gefertigten Leiterzügen verbunden sind. Um auf metallisierte Löcher zu verzichten, könnten die additiven Leiterzüge auf der Vorderseite der Kontaktierungsplatte zumindest bis an die Löcher herangeführt sein. Zudem können die flexiblen Kontaktelemente bzw. Kontaktstifte, d.h. die Kontaktelemente bzw. Kontaktstifte mit einer flexiblen Einpresszone, ein zusätzliches Federelement, z.B. in Form eines geschlitzten Rings oder Kragens, aufweisen, das die elektrische Kontaktierung realisiert. Im Bedarfsfall ist eine zusätzliche mechanische Befestigung der Gerätegehäuse bspw. mittels Anschrauben möglich. Der Vorteil dieser Ausführungsform besteht darin, dass sich die Schaltgeräte bzw. Bauelemente mechanisch abtrennen lassen und ggf. erneut mechanisch verbunden werden können. Es ist auch möglich, dass auf den gleichen Einbauplatz ein neues Bauelement bzw. Schaltgerät gesteckt wird.

Eine weitere Ausführungsform der Erfindung besteht darin, dass sich der Stiftkontakt nicht auf der Gehäuserückseite der Bauelemente befindet, sondern mechanisch fest in der Kontaktierungsplatte bzw. Backplane positioniert ist. Auch hier ist eine isolierte metallisierte Lochwandung notwendig oder alternativ nur ein Loch, welches den Stift des Kontaktelements mechanisch hält, wenn der Stift mittels eines zusätzlichen Federelements eine zusätzliche Kontaktierungsmöglichkeit aufweist, z.B. in Form eines geschlitzten Rings oder Kragens, welcher an die additive Leitstruktur kontaktiert. Die Geräte mit internen Klemmstrukturen z.B. Feder- oder Schraubkontaktierungen werden auf die Kontaktstifte der Kontaktelemente aufgesetzt. Ebenso wie im obigen Ausführungsbeispiel ist die Verbindung reversibel, kann also gelöst und wiederkontaktiert werden. Die Bauelemente weisen keine nach außen stehenden Kontaktstrukturen auf.

Eine weitere Ausführungsform der Erfindung besteht darin, dass die Kontaktstifte bzw. Kontaktelemente vor der Herstellung der additiven Leiterbahnen in Löcher der Kontaktierungsplatte bzw. Backplane gepresst werden und eine seitliche oder umlaufende Struktur aufweisen, die im Dispensprozess überdruckt wird und bereits dadurch eine elektrische Verbindung realisiert wird. Der Vorteil dieser Ausführungsform besteht darin, dass die Stiftkontakte in der Kontaktierungsplatte bzw. Backplane bereits beim additiven Herstellungsprozess der Leiterbahnen elektrisch an diese angebunden werden.

Eine weitere Ausführungsform der Erfindung besteht darin, dass Kantaktleisten verwendet werden, wenn eine Mehrzahl an Kontaktelementen benötigt wird. Diese können beispielsweise in gefräste Schlitze in der Kontaktierungsplatte bzw. Backplane mechanisch fest eingesteckt sein, ggf. auch mit einer mechanischen Verriegelung auf der Rückseite. Die jeweils seitliche elektrische Kontaktierung an die Leitbahnen auf der Backplane-Oberseite könnte z.B. bereits im Dispensprozess der Leiterbahnen erfolgen. Die Schaltgeräte bzw. Bauelemente werden dann auf die Kontaktleisten aufgesteckt und ggf. zusätzlich mechanisch befestigt. Alternativ können die Kontaktleisten seitliche Federelemente besitzen, die die Metallisierungen der Leiterbahnen kontaktieren. Der Vorteil besteht hier in einer Realisierung einer höheren Verbindungsdichte, d.h. einer höheren Anzahl von elektrischen Kontakten pro Flächeneinheit. Zudem gibt es nur planare Strukturen auf der Backplane-Oberseite und keine metallisierten Löcher.

Eine erfindungsgemäße Weiterführung dieses Konzepts kann darin bestehen, dass zwischen der Kontaktierungsplatte und der Gehäuserückseite des mindestens einen Bauelements eine thermische Anbindung zur Abfuhr von Wärme ausgebildet ist.

In einer besonders vorteilhaften Ausgestaltung der Erfindung kann es vorgesehen sein, dass mindestens ein Bauelement oder eine Mehrzahl an Bauelementen in einem Schaltschrank mit der Kontaktierungsplatte elektrisch verbunden sind.

Es ist außerdem vorteilhaft, wenn die Kontaktierungsplatte wenigstens teilweise in einem additiven Fertigungsprozess gefertigt ist.

In einer weiteren speziellen Fortführung des erfindungsgemäßen Konzepts kann es vorgesehen sein, dass der additive Fertigungsprozess ein Dispensdruck oder ein Jetting von Leiterbahnen ist.

Eine erfindungsgemäße Weiterführung dieses Konzepts kann darin bestehen, dass die Kontaktierungsplatte auf der Vorderseite und/oder auf der Rückseite Kontaktelemente aufweist.

In einer besonders vorteilhaften Ausgestaltung der Erfindung kann es vorgesehen sein, dass die Gehäuserückseite des mindestens einen Bauelements Kontaktelemente aufweist.

Es ist außerdem vorteilhaft, wenn die Kontaktelemente hinter der Backplane, d.h. der Kontaktierungsplatte, sich aufspreizende metallische Federelemente aufweisen, wobei beim Einstecken des mindestens einen Bauelements die Kontaktelemente auf der Rückseite der Kontaktierungsplatte eine elektrische und mechanische Kontaktierung ausbilden.

In einer weiteren speziellen Fortführung des erfindungsgemäßen Konzepts kann es vorgesehen sein, dass Kontaktelemente mit einer flexiblen Einpresszone an der Gehäuserückseite des mindestens einen Bauelements ausgebildet sind.

Eine erfindungsgemäße Weiterführung dieses Konzepts kann darin bestehen, dass die Kontaktelemente mit einer flexiblen Einpresszone ein zusätzliches Federelement, z.B. in Form eines geschlitzten Rings oder Kragens, aufweisen.

In einer besonders vorteilhaften Ausgestaltung der Erfindung kann es vorgesehen sein, dass die Kontaktierungsplatte mindestens ein Kontaktelement aufweist.

Es ist außerdem vorteilhaft, wenn die Kontaktelemente auf einer Kontaktleiste angeordnet sind.

Die Aufgabe der vorliegenden Erfindung wird außerdem durch ein Verfahren zur Herstellung einer Kontaktierungsplatte für eine elektrische Verbindung an mindestens ein Bauelement gelöst, wobei die Kontaktierungsplatte wenigstens teilweise in einem additiven Fertigungsprozess hergestellt wird.

Es kann vorteilhaft sein, wenn der additive Fertigungsprozess als Dispensdruck und oder Jetting von Leiterbahnen durchgeführt wird.

Die Aufgabe der vorliegenden Erfindung wird außerdem durch einen Herstellungsprozess einer elektrischen Verbindung zwischen einer Kontaktierungsplatte und mindestens einem elektrischen Bauelement gelöst, derart, dass das mindestens eine elektrische Bauelement mit seiner Gehäuserückseite zu der Kontaktierungsplatte orientiert wird, dass zwischen Kontaktierungsplatte und der Gehäuserückseite des mindestens einen elektrischen Bauelements ein Kontaktelement zur elektrische Kontaktierung und ggf. auch zur mechanischen Befestigung angeordnet wird, und durch ein Zusammenfügen des mindestens einen elektrischen Bauelements und der Kontaktierungsplatte eine elektrische Kontaktierung zwischen dem elektrischen Bauelement und der Kontaktierungsplatte und ggf. auch eine mechanische Befestigung des elektrischen Bauelements an der Kontaktierungsplatte hergestellt wird.

Die Aufgabe der vorliegenden Erfindung wird außerdem durch ein Kontaktelement für eine elektrische Kontaktierung zwischen einem elektrischen Bauelement und einer Kontaktierungsplatte gelöst, wobei die Kontaktelemente als Kontaktstifte ausgebildet sind und in der Backplane befestigt sind.

Dabei ist es vorteilhaft, wenn eine Mehrzahl an Kontaktstiften in einer Kontaktleiste ausgebildet ist.

Eine erfindungsgemäße Weiterführung dieses Konzepts kann darin bestehen, dass die Kontaktelemente neben der elektrischen Kontaktierung auch als mechanische Kontaktierung ausgebildet sind.

Die erfindungsgemäße Kontaktierungsplatte ist vorzugsweise rechteckig mit vier unterschiedlichen oder gleichen Seitenlängen ausgeführt und dient als Montageplatte mit einer mechanischen und elektrischen Anbindungsmöglichkeit an die jeweiligen Bauelemente bzw. Schaltgeräte, so dass der Verdrahtungsaufwand minimiert werden kann. Die Kontaktierungsplatte ist beispielsweise als lackiertes, blechartiges Material mit isolierendem Charakter und einer Leiterbahnstruktur ausgebildet. Zum Anschluss der Kontaktelemente, welche auf der Gehäuserückseite eines Bauelements bzw. Schaltgeräts angeordnet sind, sind in der Kontaktierungsplatte Löcher vorgesehen, so dass ein Kontaktelement mit hinter der Backplane sich aufspreizenden metallischen Federelementen durch das Loch geführt und durch die Aufspreizung der metallischen Federelemente verankert werden kann. Bei dieser Ausführungsform ist vorgesehen, dass die Leiterbahnen auf der dem Bauelement bzw. Schaltgerät abgewandten Seite der Kontaktierungsplatte angeordnet sind.

In einer weiteren Ausführungsform ist vorgesehen, dass die Kontaktelemente an der dem Bauelement zugewandten Seite an der Kontaktierungsplatte positioniert sind und durch entsprechende Zugänge im Bauelement eine elektrische Kontaktierung ermöglicht wird. Für den Fall, dass eine zusätzliche mechanische Befestigung der Kombination aus Kontaktierungsplatte und Bauelement benötigt wird, ist bspw. eine Verschraubung möglich.

Das Bauelement kann bspw. ein Niederspannungsschaltgerät sein mit einem quaderförmigen Aufbau aus einer Frontseite, welche als Anschlussseite dient und einer Montageseite, welche der Kontaktierungsplatte zugewandt ist und als Gehäuserückseite dient. Die Frontseite und die Gehäuserückseite sind über vier Seitenflächen miteinander verbunden.

Weitere Vorteile und Ausführungen der Erfindung werden nachfolgend anhand eines Ausführungsbeispiels sowie anhand der Zeichnung näher erläutert.

Dabei zeigen:
Fig. 1 in einer Seitenansicht ein Bauelement bspw. ein Schaltgerät mit einem rückseitig angebrachten Kontaktelement vor der Montage in eine erfindungsgemäße Kontaktierungsplatte.
Fig. 2 in einer Seitenansicht ein Bauelement bspw. ein Schaltgerät mit einem rückseitig angebrachten Kontaktelement nach der Montage in die erfindungsgemäße Kontaktierungsplatte.
Fig. 3 in einer Unteransicht eine erfindungsgemäße Kontaktierungsplatte mit Leiterbahnstrukturen.

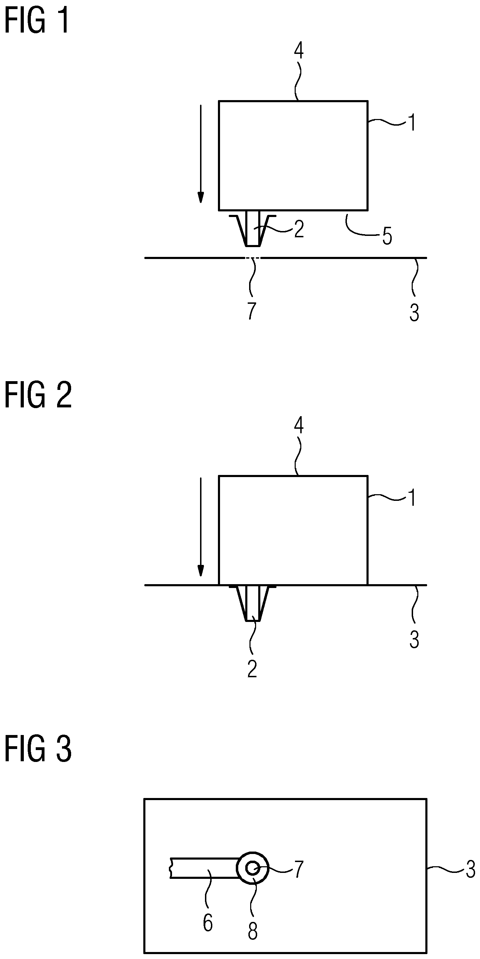

Fig. 1 zeigt ein Bauelement 1 bspw. ein Schaltgerät mit einem rückseitig angebrachten Kontaktelement 2, vorzugsweise mit einer beweglichen Kontaktfeder vor der Montage in die Kontaktierungsplatte 3. Das Bauelement 1 kann über die Kontaktelemente 2 mit der Kontaktierungsplatte 3 elektrisch und mechanisch verbunden sein. Das Bauelement 1 kann bspw. ein Niederspannungsschaltgerät sein mit einem quaderförmigen Aufbau aus einer Frontseite 4, welche als Anschlussseite dient und einer Montageseite, welche der Kontaktierungsplatte 3 zugewandt ist und als Gehäuserückseite 5 dient. Die Frontseite 4 und die Gehäuserückseite 5 sind über vier Seitenflächen miteinander verbunden. Die Kontaktelemente 2 sind an der Gehäuserückseite 5 des Bauelements bzw. Schaltgeräts angeordnet.

Die erfindungsgemäße Kontaktierungsplatte 3 ist vorzugsweise rechteckig mit vier unterschiedlichen oder gleichen Seitenlängen ausgeführt und dient als Montageplatte mit einer mechanischen und elektrischen Anbindungsmöglichkeit an die jeweiligen Bauelemente 1, so dass der Verdrahtungsaufwand minimiert werden kann. Die Kontaktierungsplatte 3 ist vorzugsweise als lackiertes Blech mit einer Leiterbahnstruktur ausgebildet. Zum Anschluss der Kontaktelemente 2, welche auf der Gehäuserückseite 5 des Bauelements 1 angeordnet sind, sind in der Kontaktierungsplatte 3 Löcher 7 vorgesehen, so dass hinter der Backplane sich aufspreizende metallische Federelemente aufweisendes Kontaktelement 2 durchgeführt und verankert werden kann. Bei dieser Ausführungsform ist vorgesehen, dass die Leiterbahnenstrukturen auf der dem Bauelement 1 abgewandten Seite der Kontaktierungsplatte 3 angeordnet sind.

Fig. 2 zeigt das Bauelement 1 bspw. ein Schaltgerät mit einem rückseitig angebrachten Kontaktelement 2 nach der Montage in die Kontaktierungsplatte 3. Das Bauelement 1 kann über die Kontaktelemente 2 mit der Kontaktierungsplatte 3 elektrisch und mechanisch verbunden sein. Für den Fall, dass eine zusätzliche mechanische Befestigung der Kombination aus Kontaktierungsplatte 3 und Bauelement 1 benötigt wird, ist bspw. eine Verschraubung möglich.

In Fig. 3 ist die Unteransicht der Kontaktierungsplatte 3 mit Leiterbahnstrukturen 6 dargestellt. Die Kontaktierungsplatte weist ein Loch 7 auf, welches den Kontakt zum Bauelement 1 ermöglicht. Um das Loch 7 ist eine gedruckte Kontaktfläche 8 dargestellt, ausgehend von welcher eine Leiterbahnstruktur 6 ausgebildet ist.

Die erfindungsgemäße Kontaktierungsplatte zeichnet sich dadurch aus, dass sie neben einer mechanischen Befestigungsfunktion als Montageplatte auch eine elektrische Kontaktierungsmöglichkeit für Bauelemente bzw. Schaltgeräte, insbesondere in einem Schaltschrank ermöglicht und damit den Verdrahtungsaufwand minimiert. Der auf individuelle Bedürfnisse anpassbare additive Fertigungsprozess bspw. in Form eines Dispensdruckes zur Herstellung der Leiterbahnstrukturen ist ein weiterer Vorteil der vorliegenden Erfindung.

### Bezugszeichenliste

- 1: Bauelement
- 2: Kontaktelement
- 3: Kontaktierungsplatte
- 4: Frontseite
- 5: Gehäuserückseite
- 6: Leiterbahnstruktur
- 7: Loch
- 8: Kontaktfläche

## Patentansprüche

1. Kontaktierungsplatte (3) für die Herstellung einer elektrischen Verbindung an mindestens ein Bauelement (1), wobei das mindestens eine Bauelement (1) eine Gehäuserückseite (5) aufweist, welche der Kontaktierungsplatte (3) gegenüberliegt, **dadurch gekennzeichnet, dass** zwischen der Kontaktierungsplatte (3) und der Gehäuserückseite (5) des mindestens einen Bauelements (1) eine elektrische Kontaktierung und eine mechanische Befestigung ausgebildet sind.

2. Kontaktierungsplatte (3) nach Anspruch 1, **dadurch gekennzeichnet, dass** zwischen der Kontaktierungsplatte (3) und der Gehäuserückseite (5) des mindestens einen Bauelements (1) eine thermische Anbindung zur Abfuhr von Wärme ausgebildet ist.

3. Kontaktierungsplatte (3) nach Anspruch 1 oder 2, **dadurch gekennzeichnet, dass** mindestens ein Bauelement (1) oder eine Mehrzahl an Bauelementen (1) in einem Schaltschrank über die Kontaktierungsplatte (3) elektrisch verbunden sind.

4. Kontaktierungsplatte (3) nach einem der Ansprüche 1 bis 3, **dadurch gekennzeichnet, dass** die Kontaktierungsplatte (3) wenigstens teilweise in einem additiven Fertigungsprozess gefertigt ist.

5. Kontaktierungsplatte (3) nach Anspruch 4, **dadurch gekennzeichnet, dass** der additive Fertigungsprozess ein Dispensdruck oder ein Jetting von Leiterbahnen ist.

6. Kontaktierungsplatte (3) nach einem der Ansprüche 1 bis 5, **dadurch gekennzeichnet, dass** die Kontaktierungsplatte (3) auf der Vorderseite und/oder auf der Rückseite Kontaktelemente (2) aufweist.

7. Kontaktierungsplatte (3) nach einem der Ansprüche 1 bis 6, **dadurch gekennzeichnet, dass** die Gehäuserückseite (5) des mindestens einen Bauelements (1) Kontaktelemente (2) aufweist.

8. Kontaktierungsplatte (3) nach Anspruch 7, **dadurch gekennzeichnet, dass** die Kontaktelemente (2) hinter der Backplane, d.h. der Kontaktierungsplatte (3), sich aufspreizende metallische Federelemente aufweisen, wobei beim Einstecken des mindestens einen Bauelements (1) die Kontaktelemente (2) auf der Rückseite der Kontaktierungsplatte (3) eine elektrische und mechanische Kontaktierung ausbilden.

9. Kontaktierungsplatte (3) nach Anspruch 7 oder 8, **dadurch gekennzeichnet, dass** Kontaktelemente (2) mit einer flexiblen Einpresszone an der Gehäuserückseite (5) des mindestens einen Bauelements (1) ausgebildet sind.

10. Kontaktierungsplatte (3) nach einem der Ansprüche 7 bis 9, **dadurch gekennzeichnet, dass** Kontaktelemente (2) mit einer flexiblen Einpresszone ein zusätzliches Federelement in Form eines geschlitzten Rings oder Kragens aufweisen.

11. Kontaktierungsplatte (3) nach einem der Ansprüche 1 bis 10, **dadurch gekennzeichnet, dass** die Kontaktierungsplatte (3) mindestens ein Kontaktelement (2) aufweist.

12. Kontaktierungsplatte (3) nach einem der Ansprüche 1 bis 11, **dadurch gekennzeichnet, dass** die Kontaktelemente (2) auf einer Kontaktleiste angeordnet sind.

13. Verfahren zur Herstellung einer Kontaktierungsplatte (3) für eine elektrische Verbindung an mindestens ein Schaltgerät (1), **dadurch gekennzeichnet, dass** die Kontaktierungsplatte (3) wenigstens teilweise in einem additiven Fertigungsprozess hergestellt wird.

14. Verfahren nach Anspruch 13, **dadurch gekennzeichnet, dass** der additive Fertigungsprozess als Dispensdruck und/oder Jetting von Leiterbahnen durchgeführt wird.

15. Herstellung einer elektrischen Verbindung zwischen einer Kontaktierungsplatte (3) und mindestens einem elektrischen Bauelement (1), wobei das mindestens eine elektrische Bauelement (1) mit seiner Gehäuserückseite (5) zu der Kontaktierungsplatte (3) orientiert wird, dass zwischen Kontaktierungsplatte (3) und der Gehäuserückseite (5) des mindestens einen elektrischen Bauelements (1) ein Kontaktelement zur elektrische Kontaktierung und ggf. auch zur mechanischen Befestigung angeordnet wird, und durch ein Zusammenfügen des mindestens einen elektrischen Bauelements (1) und der Kontaktierungsplatte (3) eine elektrische Kontaktierung zwischen dem elektrischen Bauelement (1) und der Kontaktierungsplatte (3)und ggf. auch eine mechanische Befestigung des elektrischen Bauelements (1) an der Kontaktierungsplatte (3) hergestellt wird.

16. Kontaktelement für eine elektrische Kontaktierung zwischen einem elektrischen Bauelement (1) und einer Kontaktierungsplatte (3) **dadurch gekennzeichnet, dass** die Kontaktelemente als Kontaktstifte ausgebildet sind und in der Backplane befestigt sind.

17. Kontaktelement nach Anspruch 16, **dadurch gekennzeichnet, dass** eine Mehrzahl an Kontaktstiften in einer Kontaktleiste ausgebildet ist.

18. Kontaktelement nach Anspruch 16 oder 17, **dadurch gekennzeichnet, dass** die Kontaktelemente neben der elektrischen Kontaktierung auch als mechanische Kontaktierung ausgebildet sind.
